Europäisches Patentamt

European Patent Office

Office européen des brevets

(11) Veröffentlichungsnummer: **0 281 187**
**A2**

(12) **EUROPÄISCHE PATENTANMELDUNG**

(21) Anmeldenummer: 88200307.2

(22) Anmeldetag: 22.02.88

(51) Int. Cl.⁴: **C30B 19/06**

(30) Priorität: 28.02.87 DE 3706512

(43) Veröffentlichungstag der Anmeldung:
07.09.88 Patentblatt 88/36

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB**

(72) Erfinder: **Tolksdorf, Wolfgang, Prof. Dr.**
**Dipl.-Chem.**
**Königsberger Strasse 34**
**D-2082 Tornesch(DE)**
Erfinder: **Passig, Gerd**
**Bergredder 1**
**D-2000 Barsbüttel(DE)**

(74) Vertreter: **Nehmzow-David, Fritzi-Maria et al**
**Philips Patentverwaltung GmbH**
**Wendenstrasse 35 Postfach 10 51 49**
**D-2000 Hamburg 1(DE)**

(54) Verfahren und Vorrichtung zur Herstellung epitaxialer Schichten aus schmelzflüssigen Lösungen.

(57) Verfahren und Vorrichtung zur Herstellung epitaxialer Schichten aus schmelzflüssigen Lösungen, wobei ein, an einem Substrathalter befestigtes Substrat in eine, durch Rühren vor dem Eintauchen des Substrates homogenisierte schmelzflüssige Lösung getaucht und während des Aufwachsprozesses in horizontaler Lage in der schmelzflüssigen Lösung gedreht wird, gekennzeichnet durch einen Substrathalter, der aus einem drehbar gehalterten Stab (1) besteht, an dessen unterem, in die Schmelze eintauchenden Ende mindestens ein Rührarm (3) mit mindestens einem Rührblatt (5) am Endbereich des (der) Rührarmes (Rührarme) angeordnet ist, wobei oberhalb des Rührarmes mindestens eine Aufnahme (7) für ein Substrat (9) in einem solchen Abstand zu dem Rührblatt (den Rührblättern) vorgesehen ist, daß das(die) Substrat(e) sich noch außerhalb der schmelzflüssigen Lösung (11) befindet(befinden), wenn der Rührarm (die Rührarme) mit dem Rührblatt (den Rührblättern) bereits in die schmelzflüssige Lösung eingetaucht sind.

Fig.2b

## Verfahren und Vorrichtung zur Herstellung epitaxialer Schichten aus schmelzflüssigen Lösungen

Die Erfindung betrifft ein Verfahren und eine Vorrichtung zur Herstellung epitaxialer Schichten aus schmelzflüssigen Lösungen, wobei ein an einem Substrathalter befestigtes Substrat in eine durch Rühren vor dem Eintauchen des Substrates homogenisierte, schmelzflüssige Lösung getaucht und während des Aufwachsprozesses in horizontaler Lage in der schmelzflüssigen Lösung gedreht wird.

Es ist bekannt, daß schmelzflüssige Lösungen, aus denen auf einkristallinen Substraten epitaxiale Schichten gezüchtet werden sollen, zunächst mittels eines Rührers homogenisiert werden. Dieser Rührer wird anschließend durch einen Substrathalter ersetzt, wobei das zu beschichtende Substrat an der untersten Stelle des Substrathalters befestigt ist. Um einen Temperaturausgleich zu erreichen, wird das zu beschichtende Substrat üblicherweise kurz oberhalb der Schmelze für einige Minuten auf Warteposition gebracht und danach unter Rotation des Substrathalters in die schmelzflüssige Lösung eingetaucht. Zu diesem Zeitpunkt besteht innerhalb der schmelzflüssigen Lösung keine mechanisch erzwungene Konvektion; sie setzt erst wieder ein beim Eintauchen des rotierenden Substrathalters in die schmelzflüssige Lösung. Durch die in der Zeitspanne zwischen Herausnehmen des Rührers aus der schmelzflüssigen Lösung und Eintauchen des rotierenden Substrathalters in die schmelzflüssige Lösung unterbrochene Konvektion wird der Wärmetransport in der schmelzflüssigen Lösung verändert, was zu einer Änderung der Schmelztemperatur führt, die sich erst nach mehreren Minuten auf einen anderen Wert einpendelt.

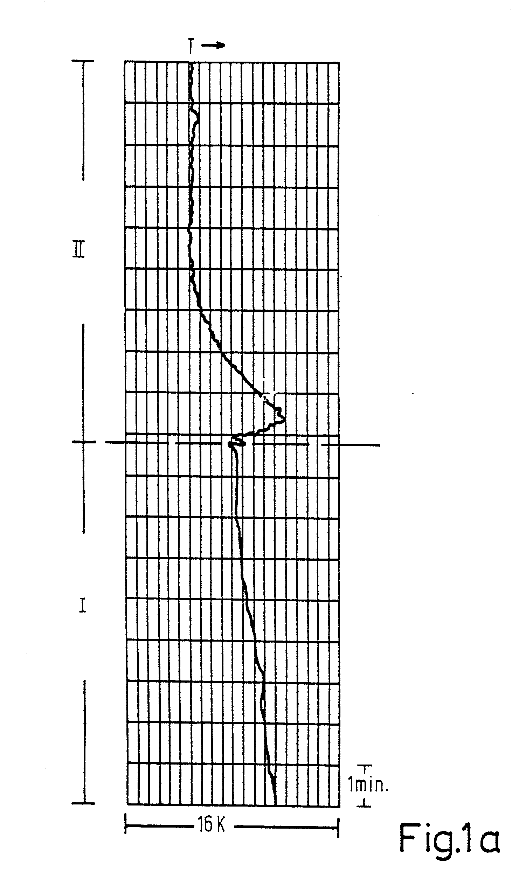

In Figur 1a ist ein Diagramm des Temperaturverlaufs in einer schmelzflüssigen Lösung mit der Temperatur I während der Wartezeit des Substrates und der Temperatur II nach Eintauchen des Substrates unter Anwendung zunächst eines Rührers und anschließend eines gegen den Rührer ausgetauschten Substrathalters gezeigt. Die Temperatur in der schmelzflüssigen Lösung wurde hierbei mit einem Thermoelement gemessen. Zunächst ist eine Temperaturerhöhung in der schmelzflüssigen Lösung um 4 K zu erkennen, danach folgt eine Abkühlung um 8 K. Durch die Änderung der Schmelztemperatur verändern sich in unerwünschter Weise die Zusammensetzung der epitaxial zu züchtenden Schicht und damit auch deren Eigenschaften.

Der Erfindung liegt die Aufgabe zugrunde, ein Verfahren und eine Vorrichtung zur Herstellung epitaxialer Schichten aus schmelzflüssigen Lösungen zu schaffen, mit denen zu jedem Zeitpunkt des Prozesses eine schmelzflüssige Lösung mit homogener Temperaturverteilung gewährleistet ist.

Diese Aufgabe wird erfindungsgemäß dadurch gelöst, daß ein Substrathalter eingesetzt wird, der unterhalb einer Aufnahme für mindestens ein zu beschichtendes Substrat mit mindestens einem Rührarm versehen ist, der an seinem äußersten Ende mindestens ein Rührblatt aufweist, daß der Substrathalter so bemessen ist, daß der (die) Rührarm(e) bereits in die schmelzflüssige Lösung eintaucht(eintauchen), wenn sich das Substrat noch oberhalb der schmelzflüssigen Lösung befindet und daß der Substrathalter vor Eintauchen des Substrates in Rotation versetzt wird und nach Homogenisierung der schmelzflüssigen Lösung soweit in die schmelzflüssige Lösung abgesenkt wird, daß das Substrat in die schmelzflüssige Lösung eintaucht.

Eine Vorrichtung zur Herstellung epitaxialer Schichten aus schmelzflüssigen Lösungen und insbesondere zur Durchführung des oben genannten Verfahrens ist gekennzeichnet durch einen Substrathalter, der aus einem drehbar gehalterten Stab besteht, an dessen unterem, in die Schmelze eintauchenden Ende mindestens ein Rührarm mit mindestens einem Rührblatt an dem (den) Endbereich(en) des Rührarmes (der Rührarme) angeordnet ist, wobei oberhalb des Rührarmes (der Rührarme) mindestens eine Aufnahme für ein Substrat in einem solchen Abstand zu dem Rührblatt (den Rührblättern) vorgesehen ist, daß das(die) Substrat(e) sich noch außerhalb der schmelzflüssigen Lösung befindet(befinden), wenn der (die) Rührarm-(e) mit dem Rührblatt (den Rührblättern) bereits in die schmelzflüssige Lösung eingetaucht ist (sind).

Mit der Erfindung sind die Vorteile verbunden, daß ein gleichförmiges Schichtwachstum von aus schmelzflüssigen Lösungen gezüchteten epitaxialen Schichten erreicht wird und damit auch gewünschte Schichteigenschaften reproduzierbar einstellbar werden. Mit dem erfindungsgemäßen Verfahren und der erfindungsgemäßen Vorrichtung können epitaxiale Schichten gezüchtet werden, die sich durch eine hohe Homogenität in bezug auf die chemische Zusammensetzung und die Dicke der Schicht auszeichnen. Darüberhinaus können Schichten sehr guter Kristallqualität erreicht werden. Auch wenn mehrere Substrate gleichzeitig in dem erfindungsgemäßen Substrathalter angeordnet werden, stören diese nicht gegenseitig das Kristallwachstum auf den Substraten.

Anhand der Zeichnung wird ein Ausführungsbeispiel der Erfindung beschrieben. Es zeigen:

Fig. 1a Temperaturverlauf innerhalb einer schmelzflüssigen Lösung bei unterbrochenem Homogenisierungsprozeß (Stand der Technik),

Fig. 1b Temperaturverlauf innerhalb einer schmelzflüssigen Lösung bei ununterbrochenem Homogenisierungsprozeß (Erfindung),

Fig.2a 2b Substrathalter gemäß der Erfindung im Schnitt in zwei Verfahrensstufen.

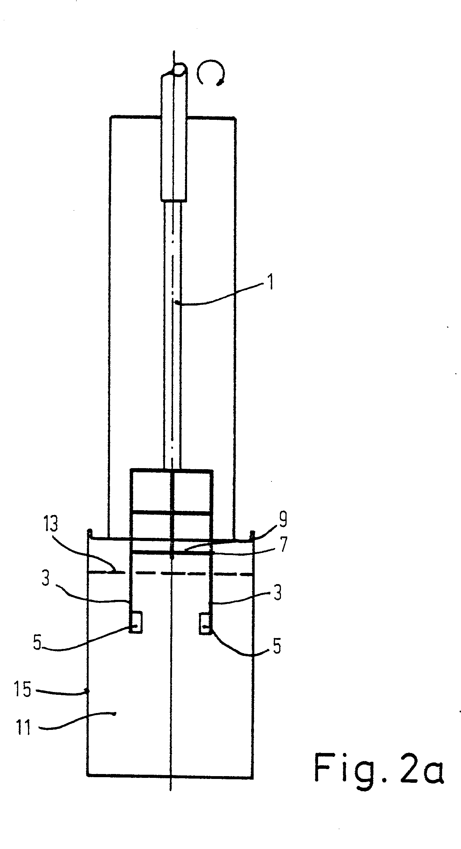

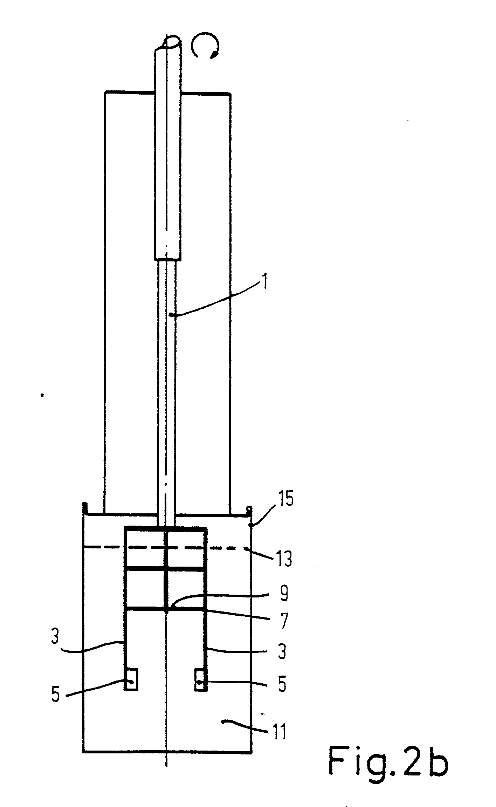

In den Figuren 2a und 2b ist ein Substrathalter gemäß der Erfindung im Schnitt dargestellt, der in ein Gefäß 15, z.B. ein Platintiegel, mit einer schmelzflüssigen Lösung 11 soweit eintaucht, daß unterhalb eines in einer Aufnahme 7 befestigten Substrates 9 befindliche Rührarme 3 mit Rührblättern 5 bereits in die - schmelzflüssige Lösung eintauchen. Der Substrathalter umfaßt einen drehbar gehalterten Stab 1 und wird bereits gedreht, wenn sich das Substrat 9 noch oberhalb der Oberfläche 13 der schmelzflüssigen Lösung 11 befindet. In Figur 2b ist die Tauchposition des Substrates 9 innerhalb der schmelzflüssigen Lösung 11 dargestellt. Durch die ununterbrochene Drehung des Substrathalters ändert sich der Wärmetransport innerhalb der schmelzflüssigen Lösung 11 nicht mehr nach dem Eintauchen des Substrates 9 in die - schmelzflüssige Lösung 11, da die Konvektionsströmung gleich bleibt.

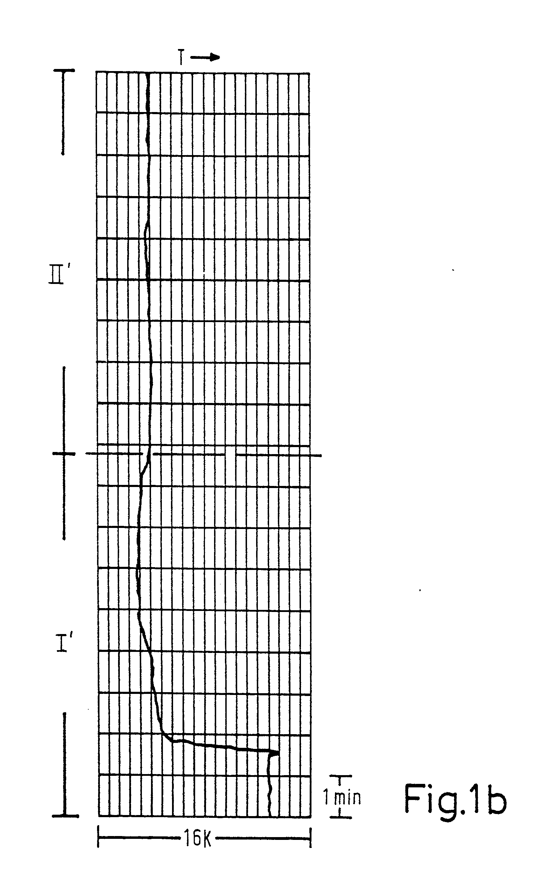

In Figur 1b ist der Temperaturverlauf innerhalb der schmelzflüssigen Lösung 11 vor Eintauchen des Substrates (Bereich I') und nach Eintauchen des Substrates 9 (Bereich II') in die schmelzflüssige Lösung 11 bei ununterbrochenem Homogenisierungsprozeß, also bei Anwendung eines erfindungsgemäßen Substrathalters, dargestellt. Es ist deutlich zu erkennen, daß die Temperatur in der schmelzflüssigen Lösung 11 innerhalb der Regelungsschwankungen konstant bleibt.

Sollen mehrere Substrate gleichzeitig mit einer epitaxialen Schicht versehen werden, hat sich ein Abstand der Substrate von 10 mm bei einem Substratdurchmesser von 32 mm bei einem Schmelzvolumen von $\approx$ 200 ml als optimal erwiesen.

Im allgemeinen ist zu sagen, daß der Abstand der Substrate abhängig ist von deren Größe und dem Volumen der Schmelze. Die Ermittlung des erforderlichen Abstandes von Fall zu Fall liegt im Bereich des fachmännischen Handelns.

Mit Hilfe der beschriebenen Vorrichtung wurden epitaxiale Granat-Schichten der nominalen Zusammensetzung $Y_{2,8}La_{0,2}Ga_{1,2}Fe_{3,8}O_{12}$ auf einem Substrat aus Gadolinium-Gallium-Granat $Gd_3Ga_5O_{12}$ gezüchtet. Diese Schichten finden vor allem Verwendung in Blasendomänen-Speicheranordnungen. Solche Magnetspeicher sind z.B. beschrieben in Elektronik 23 (1974), Seiten 39 bis 42.

Die erfindungsgemäße Vorrichtung wurde zwar für das Aufwachsen von Granat-Schichten auf Granatsubstraten benutzt, sie eignet sich aber selbstverständlich für das epitaktische Beschichten durch Tauchen eines Substrates in eine schmelzflüssige Lösung ganz allgemein.

Für die Züchtung der $Y_{2,8}La_{0,2}Ga_{1,2}Fe_{3,8}O_{12}$-Granatschichten wurde eine Schmelze der folgenden Zusammensetzung verwendet:

| | | |
|---|---:|---:|
| PbO | 1870,00 g | 90,84 Gew.% |
| $B_2O_3$ | 40,00 g | 1,95 Gew.% |
| $Fe_2O_3$ | 103,00 g | 5,00 Gew.% |
| $Y_2O_3$ | 14,50 g | 0,70 Gew.% |
| $La_2O_3$ | 10,00 g | 0,49 Gew.% |
| $Ga_2O_3$ | 21,00 g | 1,02 Gew.% |
| | 2058,50 g | 100,00 Gew.% |

Die Sättigungstemperatur der Schmelze beträgt 975 °C, die Wachstumstemperatur für die Schichten betrug 960 °C. Die Wachstumszeit für 6 µm dicke Schichten betrug 14 min bei einer Umdrehung des Substrathalters von 50 U/min mit einer Drehrichtungswechselfrequenz von 2 s.

## Ansprüche

1. Verfahren zur Herstellung epitaxialer Schichten aus schmelzflüssigen Lösungen, wobei ein an einem Substrathalter befestigtes Substrat in eine durch Rühren vor dem Eintauchen des Substrates homogenisierte schmelzflüssige Lösung getaucht und während des Aufwachsprozesses in horizontaler Lage in der - schmelzflüssigen Lösung gedreht wird, dadurch gekennzeichnet, daß ein Substrathalter eingesetzt wird, der unterhalb einer Aufnahme für mindestens ein zu beschichtendes Substrat mit mindestens einem Rührarm versehen ist, der an seinem äußersten Ende mindestens ein Rührblatt aufweist, daß der Substrathalter so bemessen ist, daß der (die) Rührarm(e) bereits in die - schmelzflüssige Lösung eintaucht (eintauchen), wenn sich das Substrat noch oberhalb der schmelzflüssigen Lösung befindet und daß der Substrathalter vor Eintauchen des Substrates in Rotation versetzt wird und nach Homogenisierung der schmelzflüssigen Lösung soweit in die schmelzflüssige Lösung abgesenkt wird, daß das Substrat in die schmelzflüssige Lösung eintaucht.

2. Verfahren nach Anspruch 1, dadurch gekennzeichnet, daß ein Substrathalter eingesetzt wird, in den mehrere Substrate zugleich einsetzbar sind und in einem Prozeßgang beschichtet werden.

3. Vorrichtung zur Herstellung epitaxialer Schichten aus schmelzflüssigen Lösungen und insbesondere zur Durchführung des Verfahrens nach den Ansprüchen 1 und 2 gekennzeichnet durch einen Substrathalter, der aus einem drehbar gehalterten Stab (1) besteht, an dessen unterem, in die Schmelze eintauchenden Ende mindestens ein Rührarm (3) mit mindestens einem Rührblatt (5) an dem (den) Endbe reich(en) des Rührarmes (der Rührarme) angeordnet ist, wobei oberhalb des Rührarmes (der Rührarme) mindestens eine Aufnahme (7) für ein Substrat (9) in einem solchen Abstand zu dem Rührblatt (den Rührblättern) vorgesehen ist, daß das(die) Substrat(e) sich noch außerhalb der schmelzflüssigen Lösung (11) befindet (befinden), wenn der (die) Rührarm(e) mit dem Rührblatt (den Rührblättern) bereits in die schmelzflüssige Lösung eingetaucht ist (sind).

4. Vorrichtung nach Anspruch 3, dadurch gekennzeichnet, daß der Substrathalter mehrere Aufnahmen (7) für Substrate (9) aufweist.

5. Vorrichtung nach den Ansprüchen 3 und 4, dadurch gekennzeichnet, daß die Aufnahme(n) (7) für das(die) Substrat(e) (9), der (die) Rührarm(e) (3) und das Rührblatt (die Rührblätter) (5) des Substrathalters aus Platin oder einer Platinlegierung bestehen.

Fig.1a

Fig.1b

Fig. 2a

Fig.2b